# FASCICULE DE BREVET EUROPEEN

(11) **EP 3 579 286 B1**
(45) Date de publication et mention de la délivrance du brevet: **20.01.2021**
(21) Numéro de dépôt: 19177162.5
(22) Date de dépôt: 29.05.2019
(51) Int. Cl.: H01L 33/62, H01L 23/498

(54) **PUCE PHOTONIQUE TRAVERSÉE PAR UN VIA**
PHOTONENCHIP, DER VON EINER LEITUNG DURCHZOGEN WIRD
PHOTONIC CHIP PENETRATED BY A VIA

(30) Priorité: 08.06.2018 FR 1855010
(43) Date de publication de la demande: 11.12.2019
(73) Titulaire: Commissariat à l'Énergie Atomique et aux Énergies Alternatives, 75015 Paris (FR)
(72) Inventeur: MENEZO, Sylvie, 38054 GRENOBLE Cedex 9 (FR); CHERAMY, Séverine, 38054 GRENOBLE Cedex 9 (FR)
(74) Mandataire: Colombo, Michel

(56) Documents cités:
- FR-A1- 3 023 066
- US-A1- 2011 291 153
- US-A1- 2012 155 055
- US-A1- 2013 292 735
- US-A1- 2014 133 105
- US-A1- 2015 348 906
- US-A1- 2016 141 467
- YAN YANG ET AL: "Through-Si-via (TSV) Keep--out-Zone (KOZ) in SOI Photonics Interposer: A study of the impact of TSV-Induced Stress on Si Ring Resonators", IEEE PHOTONICS JOURNAL, vol. 5, no. 6, 13 décembre 2013 (2013-12-13), XP002788522,

## Description

L'invention concerne une puce photonique traversée par un via ainsi qu'un procédé de fabrication d'une telle puce photonique.

Un via est une connexion électrique verticale, c'est-à-dire qui s'étend principalement dans une direction perpendiculaire au plan de la puce photonique.

Les puces photoniques s'étendent essentiellement dans un plan appelé par la suite « plan de la puce ».

Les puces photoniques connues comportent :
- un substrat présentant des faces supérieure et inférieure parallèles au plan de la puce, ce substrat comportant, entre les faces supérieure et inférieure :
   - une couche d'interconnexion d'épaisseur supérieure à 50 µm, cette couche d'interconnexion étant dépourvue de composant optique,
   - une couche optique collée, au niveau d'une interface de collage, sur la couche d'interconnexion,
   - au moins un composant optique enterré à l'intérieur de la couche optique,
   - une borne électrique choisie dans le groupe constitué d'un contact électrique enfoui à l'intérieur de la couche optique, ce contact électrique enfoui étant celui du composant optique ou d'un composant électronique, et d'une piste électrique réalisée sur la face supérieure du substrat,
- des plots de raccordement électrique réalisés sur la face inférieure du substrat, chacun de ces plots étant apte à être connecté électriquement par l'intermédiaire d'une bille de soudure à un autre support,
- un via primaire s'étendant à travers la couche d'interconnexion depuis la face inférieure pour raccorder électriquement l'un des plots de raccordement à la borne électrique, ce via primaire ayant un diamètre supérieur ou égal à 10 µm.

Une telle puce photonique est par exemple décrite dans l'article suivant : Yan Yang et Al : « Though-Si-via (TSV), Keep-Out-Zone (KOZ) in SOI photonics interposer : A study of impact of TSV-Induced stress on Si ring resonators », IEEE Photonics Journal, volume 5, Number 6, December 2013. Par la suite, cet article est désigné par la référence « Yang2013 ».

Il est connu que la présence de via traversants à proximité d'un composant optique pose des problèmes. En effet, de tels via sont réalisés dans un matériau électriquement conducteur, dont le coefficient de dilatation thermique est différent du matériau dans lequel est réalisé le composant optique. Ainsi, en réponse à des variations de température, les via exercent sur le composant optique situé à proximité une contrainte mécanique qui varie en fonction de la température. Cette variation de la contrainte mécanique modifie les propriétés optiques du composant optique et entraîne une modification des propriétés de ce composant optique. Par exemple, lorsque le composant optique est un filtre optique, cela modifie sa longueur d'onde centrale. De telles variations des propriétés du composant optique doivent être évitées.

Pour cela, l'article Yang2013 propose d'éloigner les via traversants des composants optiques. Plus précisément, il propose de définir une zone d'exclusion autour de chaque via. A l'intérieur de chaque zone d'exclusion, aucun composant optique ne doit être implanté. Il a été démontré que cette zone d'exclusion est d'autant plus grande que le diamètre du via traversant est important.

Par ailleurs, une puce photonique doit avoir une épaisseur suffisamment importante pour être assez rigide et ne pas présenter une flèche trop importante. Or, les procédés de fabrication des via traversants génèrent des limitations sur l'épaisseur de la puce photonique. Typiquement, les puces comprenant des via traversants ont une épaisseur supérieure à 50 µm ou 100 µm. Il a par ailleurs été montré, dans le cas des substrats SOI (« Silicon On Insulator »), que des via traversants une couche d'oxyde enterrée, engendrent une flèche plus importante que lorsque ces via sont réalisés dans un substrat de même épaisseur mais dépourvu d'une telle couche d'oxyde enterrée. Ainsi, afin de ne pas présenter une flèche trop importante, si l'épaisseur minimale pour une puce avec via formés dans un substrat en silicium est de 100 µm, cette épaisseur doit être typiquement d'au moins 150 µm pour une puce avec via formés dans un substrat SOI.

Généralement, plus un via doit traverser un substrat d'épaisseur importante, plus son diamètre est important. Typiquement, il est possible de fabriquer des via de facteur de forme « hauteur sur diamètre» de 8 pour 1 (noté 8/1 par la suite), voire 10 pour 1 mais très difficilement de facteur de forme supérieur à 10 pour 1. Ainsi, à ce jour, dans les puces photoniques existantes, la hauteur et le diamètre des via traversants la puce photonique et en particulier, traversant un niveau de guidage optique contenant des composants optiques, sont importants. Actuellement, la hauteur et le diamètre de ces via doivent typiquement être supérieurs, respectivement, à 100 µm et à 10 µm voire supérieurs, respectivement, à 150µm et à 20 µm. Par conséquent, la surface des zones d'exclusion est grande. Or, plus la surface des zones d'exclusion est grande, plus cela augmente les contraintes à respecter pour le placement des composants optiques. Cela rend donc plus difficile la conception et la fabrication de telles puces photoniques. Cela augmente également la taille de telles puces photoniques du fait de l'existence de ces zones d'exclusion.

Par ailleurs de l'état de la technique est connu de FR3023066A1, US2016/141467A1, US2015/348906, US2014/133105A1, US2011/291153A1, US2012/155055A1 et US2013/292735A1. Toutefois, cet état de la technique ne traite pas du problème du placement des composants optiques en respectant des zones d'exclusions.

L'invention vise à simplifier la conception et la fabrication de ces puces photoniques en proposant une structure de puce photonique qui permet de relâcher les contraintes à respecter pour le placement des composants optiques.

Elle a donc pour objet une puce photonique conforme à la revendication 1.

Les modes de réalisation de cette puce photonique peuvent comporter une ou plusieurs des caractéristiques des revendications dépendantes.

L'invention a également pour objet un procédé de fabrication de la puce photonique, objet de la présente demande.

Les modes de réalisation de ce procédé de fabrication peuvent comporter une ou plusieurs des caractéristiques des revendications dépendantes.

L'invention sera mieux comprise à la lecture de la description qui va suivre. Elle est donnée uniquement à titre d'exemple non limitatif tout en se référant aux dessins sur lesquels :
- la figure 1 est une illustration schématique d'un système comportant une puce photonique ;
- la figure 2 est une illustration schématique, en coupe verticale, de la puce photonique du système de la figure 1 ;
- la figure 3 est un organigramme d'un procédé de fabrication du système de la figure 1;
- les figures 4 à 10 sont des illustrations schématiques, en coupe verticale, de différents états de fabrication de la puce photonique de la figure 2 ;
- la figure 11 est une illustration schématique, en coupe verticale, d'une première variante de la puce photonique de la figure 2 ;
- la figure 12 est une illustration schématique, en coupe verticale, d'une deuxième variante de la puce photonique de la figure 2.
Dans ces figures, les mêmes références sont utilisées pour désigner les mêmes éléments. Dans la suite de cette description, les caractéristiques et les fonctions bien connues de l'homme du métier ne sont pas décrites en détail.

### Chapitre I : Exemples de modes de réalisation

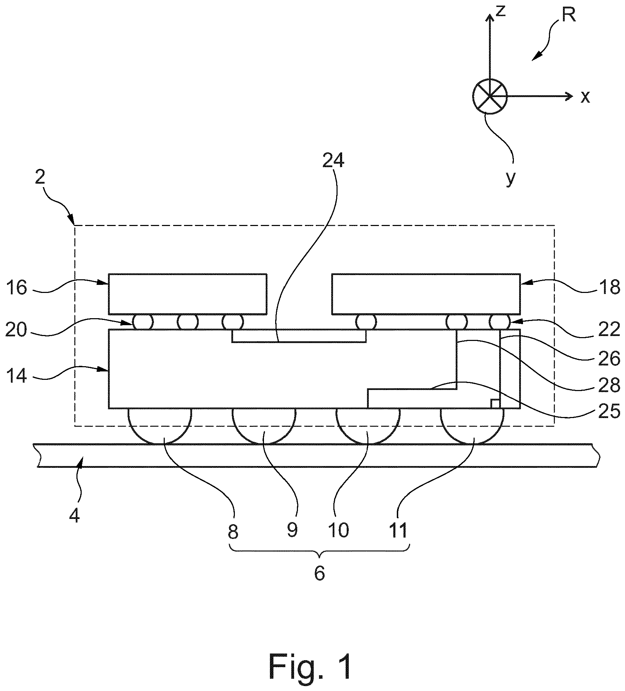

La figure 1 représente une portion d'un système 2 soudé sur un circuit imprimé 4 ou PCT (« Printed Circuit Board ») par l'intermédiaire d'un réseau 6 de billes de soudure (en anglais, « Solder bumps »). Pour simplifier l'illustration, seules quatre billes 8 à 11 du réseau 6 sont représentées.

Le système 2 se présente typiquement sous la forme d'un boîtier parallélépipédique à l'intérieur duquel sont logés des puces électroniques et optiques. Seules les billes de soudure du système 2 font saillie sur une face inférieure de ce boîtier. Pour simplifier l'illustration, ce boîtier n'a pas été représenté sur la figure 1. Le système 2 dans son boîtier est connu sous le nom anglais de 'system in package'. De façon plus générique, le système 2 est aussi souvent désigné par le terme « circuit-intégré ».

Dans la suite de cette description, l'horizontal est défini sur les figures par des directions X et Y d'un repère orthogonal R. La direction Z du repère R correspond à la direction verticale. Les termes tels que « inférieur », « supérieur », « dessus », « dessous », « haut » et « bas » sont définis par rapport à cette direction Z.

Dans sa partie inférieure, le système 2 comporte un support 14. Les billes du réseau 6 sont placées directement sur la face inférieure du support 14. L'ensemble du support 14 et du réseau 6 est connu sous l'acronyme BGA (« Ball Grid Array »). La face supérieure du support 14 comporte des plots sur lesquels des puces électroniques et/ou photoniques peuvent être soudées. Dans le cas particulier de la figure 1, le système 2 comporte une puce électronique 16 et une puce photonique 18. Ces deux puces 16 et 18 sont toutes les deux directement soudées sur la face supérieure du support 14.

La puce électronique comporte uniquement des composants électroniques raccordés les uns aux autres pour réaliser des fonctions prédéterminées. La puce électronique 16 est donc dépourvue de composant optique.

A l'inverse, la puce photonique 18 comporte des composants optiques pour remplir des fonctions prédéterminées. Un composant optique est un composant qui, au cours de son utilisation, génère ou modifie ou guide un signal optique. Typiquement, la longueur d'onde λ du signal optique est comprise entre 1200 nm et 1700 nm. Généralement, au moins un de ces composants optiques est un composant optique actif, c'est-à-dire un composant optique :
- qui doit être alimenté par un courant ou une tension électrique pour fonctionner correctement, et/ou
- qui convertit un signal optique en un signal électrique (cas d'un photo-détecteur), ou convertit un signal électrique en un signal optique (cas d'un modulateur de lumière).

Dans ce mode de réalisation, la puce photonique 18 est dépourvue de composant électronique.

Pour être alimentées en électricité ou pour échanger des signaux électriques, la puce photonique 18 et la puce électronique 16 du système 2 sont électriquement raccordées à des plots de la face supérieure du support 14. Les puces 16 et 18 sont également raccordées électriquement au circuit imprimé 4. A cet effet, ici, les puces 16 et 18 sont soudées sur des plots respectifs de la face supérieure du support 14 par l'intermédiaire de réseaux, respectivement 20 et 22, de microbilles de soudure. Sur la figure 1, les réseaux 20 et 22 sont représentés par quelques-unes de ces microbilles de soudure situées sous les puces 16 et 18. Par exemple, les microbilles de soudure sont connues sous le terme anglais de « C4 Bumps ».

Le support 14 comporte des connexions électriques qui s'étendent principalement horizontalement, telle qu'une connexion 24. La connexion 24 relie électriquement certains plots de la face supérieure du support 14 entre eux afin de permettre l'échange de signaux électriques ou d'alimentation électrique entre les puces soudées sur ces plots. Le support 14 est aussi traversé par des connexions verticales, telles que des connexions 26 et 28. Généralement, ces connexions verticales débouchent sur une ligne de métal horizontale d'une couche de redistribution plus connue sous l'acronyme RDL (« Redistribution layer »). Ici, une seule ligne 25 de cette couche de redistribution est illustrée. Les lignes horizontales de la couche de redistribution relient électriquement certaines des connexions verticales à des billes de soudure correspondantes du réseau 6. Les connexions verticales permettent notamment d'alimenter électriquement les puces 16 et 18 et, aussi, d'échanger des signaux électriques avec d'autres puces soudées sur le circuit imprimé 4. En dehors des connexions horizontales et verticales, le support 14 est généralement dépourvu de tout autre composant électrique ou optique.

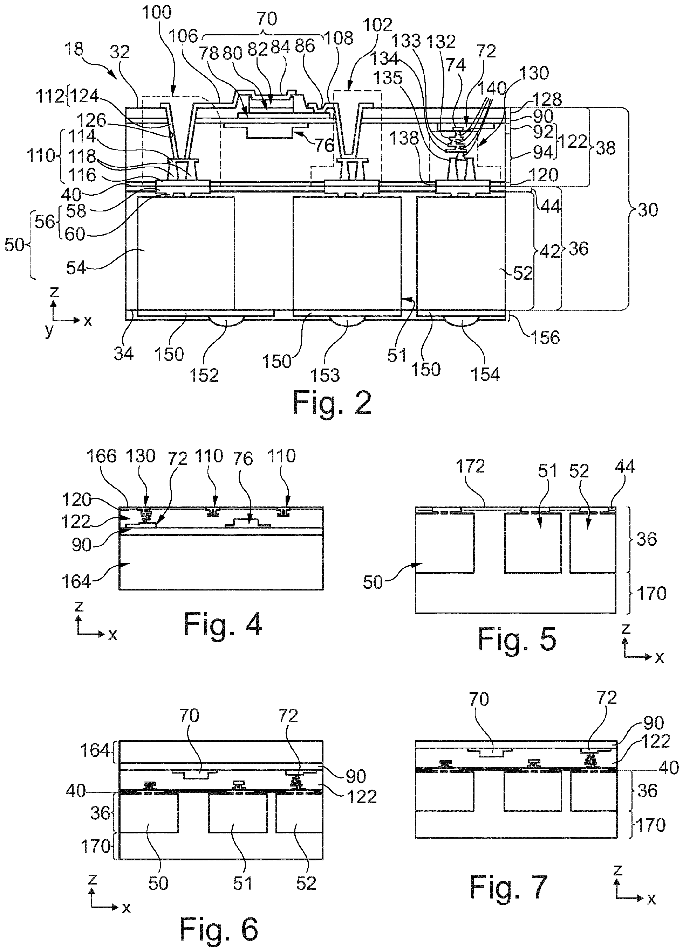

La figure 2 représente plus en détail une portion de la puce photonique 18. La puce 18 comporte un substrat 30 présentant une face supérieure horizontale 32 et une face inférieure horizontale 34. Entre ces faces 32 et 34, le substrat 30 comporte, directement empilées l'une sur l'autre, en allant du bas vers le haut :
- une couche 36 d'interconnexion, et
- une couche optique 38.

Plus précisément, les couches 36 et 38 sont directement collées l'une sur l'autre au niveau d'une interface 40 de collage qui s'étend essentiellement dans un plan horizontal. La face supérieure de la couche 38 correspond à la face supérieure 32 et la face inférieure de la couche 36 correspond à la face inférieure 34.

La couche 36 est principalement réalisée dans un matériau non-conducteur. Dans cette description, on désigne par « matériau non-conducteur » un matériau dont la conductivité à 20°C est inférieure à 10⁻¹ ou 10⁻² S/m. Ainsi, ce matériau non-conducteur peut être un matériau semi-conducteur tel que le silicium non dopé ou un matériau électriquement isolant tel que le verre. Ici, le matériau non-conducteur est du silicium cristallin non dopé. A l'inverse, dans cette description, on désigne par « matériau conducteur » ou « matériau électriquement conducteur » un matériau dont la conductivité électrique à 20°C est généralement supérieure à 10⁵ ou 10⁶ S/m.

Ici, la couche 36 comporte une sous-couche 42 en silicium cristallin non dopé et une sous-couche superficielle 44 réalisée directement sur la sous-couche 42. Ici la sous-couche 44 est réalisée en dioxyde de silicium.

La face inférieure de la sous-couche 42 correspond à la face 34. L'épaisseur de la sous-couche 42 est assez importante pour être assez rigide et ne pas présenter une flèche trop importante. En particulier, l'épaisseur de la sous-couche 42 est suffisante pour permettre de manipuler la puce 18. A cet effet, l'épaisseur de la sous-couche 42 est supérieure à 50 µm ou à 80 µm ou à 100 µm. La sous-couche 42 comporte des via, appelés par la suite « via primaires » qui permettent de former des connexions électriques qui traversent verticalement le substrat 30. Chaque via primaire s'étend depuis une extrémité inférieure jusqu'à une extrémité supérieure. L'extrémité inférieure affleure la face inférieure 34. L'extrémité supérieure affleure l'interface 40 de collage. Ces via primaires traversent donc la totalité de l'épaisseur de la couche 36 d'interconnexion. Par contre, les via primaires ne traversent pas et ne pénètrent pas à l'intérieur de la couche optique 38.

La couche 36 ne contient pas de couche d'oxyde de silicium enterré. Son épaisseur minimale donnant lieu à une flèche acceptable est donc moindre que celle d'une couche qui contiendrait une telle couche d'oxyde de silicium enterré. Avoir une épaisseur moindre permet notamment de diminuer les capacités parasites des via primaires qui est proportionnelle à la hauteur des via primaires. Ainsi, de préférence, l'épaisseur de la sous-couche 42 est également inférieure à 150 µm ou 100 µm.

La figure 2 représente seulement trois via primaires 50 à 52. Toutefois, en général, la couche 36 comporte un nombre bien plus important de via primaires. Par exemple, tous les via primaires sont identiques de sorte que par la suite, seul le via primaire 50 est décrit plus en détail.

Le via primaire 50 est réalisé de façon conventionnelle. Par exemple, à ce sujet, le lecteur peut consulter l'article suivant : Ken Miyairi et Al : « Full intégration and electrical characterization of 3D Silicon Interposer demonstrator incorporating high density TSVs and interconnects », 45th International Symposium on Microelectronics, 2012. Ainsi, par la suite seuls quelques détails du via 50 sont décrits.

Dans ce mode de réalisation, le via 50 est formé, en allant du bas vers le haut :
- d'une partie inférieure 54 en forme de barreau vertical, et
- d'une partie supérieure 56 en forme de réseau de métal d'interconnexion.

La partie inférieure 54 s'étend verticalement de l'extrémité inférieure du via 50 jusqu'à la partie supérieure 56. La section horizontale de la partie inférieure est sensiblement constante sur toute sa hauteur. Sa hauteur et son diamètre sont par la suite notés, respectivement, H1 et D1. La partie inférieure 54 traverse au moins 80 % et, de préférence, au moins 90 % ou 95 % de l'épaisseur de la couche 36. Étant donné que l'épaisseur de la couche 36 est importante, le diamètre D1 est également important pour que le rapport de forme H1/D1 soit inférieur à 10/1 ou 8/1. En effet, il est difficile de fabriquer des via ayant un rapport de forme supérieur à 10/1. Ici, la hauteur H1 est supérieure à 80 % ou 90 % ou 95 % de l'épaisseur de la sous-couche 42. Dans ces conditions, la hauteur H1 est comprise entre 80 µm et 142,5 µm et, généralement, comprise entre 95 µm et 130 µm. Le diamètre D1 est alors typiquement compris entre 10 µm et 20 µm.

La partie supérieure 56 du via 50 est formée par un réseau de métal d'interconnexion. Cette partie supérieure 56 se compose donc :
- de lignes de métal qui s'étendent principalement horizontalement, et
- de via métalliques qui raccordent électriquement entre elles ces lignes de métal.

Les lignes de métal sont réalisées dans la sous-couche 44 d'oxyde de silicium. Ici, la partie supérieure 56 comporte :
- une ligne de métal 58 qui affleure l'interface 40 de collage, et
- des via métalliques 60 qui raccordent cette ligne 58 directement au sommet de la partie inférieure 54.

Dans cette description, par « via métallique », on désigne un via réalisé en métal et dont le diamètre est petit, c'est-à-dire dont le diamètre est inférieur à 3 µm et, généralement, inférieur à 1 µm. La hauteur d'un via métallique est également petite, c'est-à-dire inférieure à 3 µm ou 1 µm.

Ici, le métal est du cuivre. La structure d'un tel réseau de métal d'interconnexion est bien connue de l'homme du métier. Il s'agit de réseau de métal d'interconnexion de la couche de redistribution ou RDL.

L'épaisseur de la sous-couche 44 est typiquement inférieure à 10 µm ou 3 µm.

Le diamètre de la partie supérieure 56 est égal au plus grand diamètre d'un via métallique qui la compose. Ici, le diamètre de la partie supérieure 56 est donc inférieur à 10 µm et, généralement, inférieur à 3 µm ou à 1 µm.

La couche optique 38 comporte au moins un composant optique enterré à l'intérieur de cette couche. Ici, le composant optique est choisi dans le groupe constitué d'un modulateur optique, d'une source laser, d'un guide d'onde, d'un photodétecteur, d'un démultiplexeur et d'un multiplexeur optique. Parmi les composants optiques de ce groupe, tous sont des composants optiques actifs à l'exception du guide d'onde.

Dans cet exemple de réalisation, seuls deux composants optiques 70, 72 enterrés dans la couche 38 sont représentés. Le composant 70 est une source laser et le composant 72 est un modulateur optique. Le composant 72 est capable de modifier, en fonction d'un signal électrique de commande, la phase, l'amplitude ou l'intensité d'un signal optique qui le traverse. De tels modulateurs optiques sont bien connus de sorte que le composant 72 n'est pas décrit ici en détail. Le composant 72 comporte un contact électrique 74 destiné à recevoir le signal électrique de commande. Ici, ce contact électrique 74 est enfoui à l'intérieur de la couche optique 38. Dans ce mode de réalisation, le contact électrique 74 est situé sur une face inférieure du composant 72. Le contact électrique 74 est donc tourné vers l'interface 40 de collage. Dans cette configuration, le contact électrique 74 est uniquement accessible par le dessous du composant optique 72.

Le composant 70 est une source laser hétérogène III-V/Silicium. Le composant 70 est par exemple une source laser connue sous l'acronyme DFB (« Distributed Feedback Laser ») ou DBR (« Distributed Bragg Reflector Laser »). Une telle source laser est bien connue de l'homme du métier et n'est donc pas décrite en détail ici. Ici, le composant 70 comporte notamment, un guide d'onde 76 et, empilées directement les unes sur les autres :
- une couche inférieure 78 en matériau semi-conducteur présentant un dopage N,
- une couche active 80, et
- une couche supérieure 82 en matériau semi-conducteur présentant un dopage P.

Le composant 70 comporte également une prise supérieure 84 et une prise inférieure 86 directement en contact, respectivement, avec les couches supérieure 82 et inférieure 78.

La couche active 80 génère le signal optique émis par le composant 70 lorsqu'une différence de potentiels appropriée est appliquée entre les prises 84 et 86.

Ici, la couche inférieure 78 est couplée optiquement au guide d'onde 76. Pour cela, la couche 78 est disposée au-dessus du guide d'onde 76 et séparée de ce guide d'onde 76 par une mince sous-couche 90 d'oxyde enterré. Par exemple, l'épaisseur de la sous-couche d'oxyde 90 est inférieure à 100 nm et, de préférence, inférieure à 50 nm ou 20 nm. Ainsi, le signal optique généré par la couche active 80 peut ensuite être guidé par le guide d'onde 76.

Ici, le guide d'onde 76 et le composant optique 72 sont enterrés à l'intérieur d'une sous-couche 122 d'encapsulation située directement sous la sous-couche 90 d'oxyde. Plus précisément, la sous-couche 122 s'étend depuis une sous-couche 120 jusqu'à la sous-couche 90. La sous-couche 122 se décompose ici en un niveau supérieure 92 de guidage optique et en un niveau inférieur 94 d'interconnexion électrique. Le niveau 92 comprend tous les composants optiques et parties de composants optiques réalisés sous la sous-couche 90. Le niveau 92 comprend donc ici le guide d'onde 76, le composant optique 72 et un matériau diélectrique dans lequel les composants optiques et parties de composants optiques sont encapsulés. Par exemple, ce niveau 92 est fabriqué à partir d'une sous-couche en silicium cristallin dans laquelle ont été fabriqués le guide d'onde 76 et le composant 72 avant d'être encapsulés dans le matériau diélectrique. Le niveau 94 est dépourvu de composant optique et de partie de composant optique. Ici, le niveau 94 comporte des réseaux de métal d'interconnexion encapsulés dans un matériau diélectrique comme cela sera décrit plus loin. Le matériau diélectrique de la sous-couche 122 présente un indice de réfraction inférieur à l'indice de réfraction du matériau utilisé pour réaliser le guide d'onde 76 et le composant 72. Par exemple, le matériau diélectrique est le dioxyde de silicium.

Les couches 78, 80 et 82 sont quant à elles réalisées dans une sous-couche 128 située directement sur la sous-couche 90. La sous-couche 128 comporte ici un matériau III-V dans lequel sont réalisées les couches 78, 80 et 82 et un matériau diélectrique qui encapsule les couches 78, 80 et 82. La sous-couche 128 s'étend horizontalement directement au-dessus de la sous-couche 90 et sa face supérieure correspond à la face 32.

Pour alimenter et/ou transmettre des signaux électriques à travers la couche 38, cette couche 38 comporte des via, appelés « via secondaires ». Chaque via secondaire prolonge un via primaire à l'intérieur de la couche optique 38. A cet effet, chaque via secondaire s'étend depuis l'interface 40 de collage vers l'intérieur de la couche 38. Pour limiter les contraintes à respecter sur le placement des composants optiques par rapport à ces via secondaires, le diamètre des via secondaires est beaucoup plus petit que le diamètre des via primaires. Ici, le diamètre des via secondaires est inférieur à 3 µm et, de préférence, inférieur à 1 µm. Pour faciliter la réalisation de tels via secondaires, l'épaisseur de la couche 38 est inférieure à 15 µm ou ou 8 µm ou 5 µm.

Par la suite, on classe les via secondaires en deux catégories. Une première catégorie appelée « via secondaire traversant » et une seconde catégorie appelée « via secondaire non-traversant ».

Les via secondaires traversant traversent l'épaisseur de la couche 38 et donc, en particulier, le niveau 92 de guidage optique. Ils s'étendent donc verticalement depuis l'interface 40 de collage jusqu'à la face supérieure 32. Ils sont typiquement utilisés pour raccorder électriquement des pistes électriques formées sur la face supérieure 32 à l'un des via primaires. A l'inverse, les via secondaires non-traversants ne traversent pas complètement l'épaisseur de la couche 38 et, en particulier, ne traversent pas le niveau 92 de guidage optique. Ils s'étendent donc depuis l'interface 40 de collage jusqu'à un contact électrique, tel que le contact 74, enfoui à l'intérieur de la couche 38.

A titre d'illustration, la figure 2 représente deux via secondaires traversants 100 et 102. Le via 100 raccorde électriquement le via primaire 50 à une piste électrique 106 réalisée sur la face 32. Ici, la piste 106 raccorde électriquement l'extrémité supérieure du via 100 à la prise 84. L'extrémité inférieure du via 100 est directement en contact mécanique et électrique avec la ligne de métal 58.

Le via secondaire traversant 102 raccorde électriquement le via primaire 51 à une piste électrique 108 réalisée sur la face 32. La piste 108 raccorde électriquement l'extrémité du via 102 à la prise 86. L'extrémité inférieure du via 102 est directement en contact mécanique et électrique avec la ligne de métal du via 51. Ici, les via 100 et 102 sont utilisés pour alimenter le composant 70.

La structure du via 102 est identique à celle du via 100. Ainsi, seule la structure du via 100 est décrite ci-dessous plus en détail.

Dans ce mode de réalisation, le via 100 comporte une partie inférieure 110 et une partie supérieure 112 disposées immédiatement l'une au-dessus de l'autre. Les parties 110 et 112 sont réalisées, lors de la fabrication, à partir de côtés opposés de la couche optique.

La partie inférieure 110 est un réseau de métal d'interconnexion. Ici, cette partie 110 comporte :
- une ligne de métal 114 enfouie à l'intérieur du niveau 94 de la sous-couche 122 ,
- une ligne de métal 116 qui affleure l'interface 40 de collage, et
- des via métalliques 118 qui s'étendent verticalement directement depuis la ligne de métal 116 jusqu'à la ligne de métal 114.

Le diamètre de la partie inférieure 110 est défini de la même manière que pour la partie supérieure 58 du via primaire 50. Le diamètre de la partie 110 est inférieur à 3 µm ou à 1 µm.

Dans ce mode de réalisation, le réseau de métal d'interconnexion qui forme la partie 110 comporte seulement deux niveaux de lignes de métal. Par exemple, il s'agit des niveaux souvent désignés par les références M4 et M5.

Généralement, la hauteur de cette partie 110 est faible, c'est-à-dire inférieure à 6 µm ou 3 µm ou 1µm.

Ici, la ligne de métal 116 est réalisée dans une sous-couche d'oxyde de silicium 120 dont la face inférieure est confondue avec l'interface 40 de collage. La sous-couche 120 est directement réalisée sous la sous-couche 122. Ici, la sous-couche 120 est réalisée en dioxyde de silicium.

Les via métalliques 118 sont situés à l'intérieur du niveau 94 de la sous-couche 122.

La partie supérieure 112 du via secondaire 100 est formée d'un revêtement 124 en matériau conducteur. Par exemple, le revêtement 124 est réalisé en cuivre ou en aluminium. Ce revêtement 124 recouvre continûment les parois verticales et le fond d'un trou 126 creusé dans la couche 38. Plus précisément, le trou 126 s'étend depuis la face supérieure 32 jusqu'à la ligne de métal 114. Pour cela, le trou 126 traverse successivement en allant du haut vers le bas, la couche 128 d'encapsulation, la sous-couche 90, le niveau 92 de guidage optique et une partie du niveau 94 de la sous-couche 122.

Le diamètre maximal du trou 126 est inférieur à 3 µm et, de préférence, inférieur à 1 µm. Ainsi, le diamètre maximal de la partie supérieure 112 du via secondaire 100 est également inférieur à 3 µm ou 1 µm.

Dans sa partie supérieure, le revêtement 124 est directement en contact mécanique et électrique avec la piste 106 et, dans sa partie inférieure, directement en contact mécanique et électrique avec la ligne de métal 114. Dans l'exemple de la figure 2, le revêtement 124 ne remplit pas la totalité du trou 126. Le centre du trou 126 est donc évidé. Pour cela, par exemple, l'épaisseur du revêtement 124 est inférieure à 500 nm ou 300 nm. Le centre du trou 126 est rempli d'un matériau électriquement non-conducteur et passivant. Avantageusement, le coefficient de dilatation de ce matériau électriquement non-conducteur est inférieur à 0,8C₁₂₄, et de préférence inférieur à 0,5C₁₂₄ ou 0,3C₁₂₄, où C₁₂₄ est le coefficient de dilatation thermique du revêtement 124. Ici, le centre du trou 126 est rempli par le même matériau diélectrique que celui de la sous-couche 122, c'est-à-dire du dioxyde de silicium.

La couche 38 comporte également un via secondaire non-traversant 130. Le via 130 raccorde électriquement le contact électrique 74 à l'extrémité supérieure du via primaire 52 pour recevoir le signal électrique de commande du composant optique 72. A cet effet, le via 130 s'étend verticalement depuis l'interface 40 de collage jusqu'au contact électrique 74. Il traverse donc complètement la sous-couche 120 et le niveau 94 de la sous-couche 122. Par contre, il ne traverse pas le niveau 92 de guidage optique ni la sous-couche 90. Le via 130 ne débouche pas dans la face supérieure 32 contrairement à un via secondaire traversant.

Le via 130 est uniquement fabriqué à partir du côté de la couche 38 tourné vers l'interface 40 de collage. Ici, le via 130 est formé par un réseau de métal d'interconnexion. Dans ce mode de réalisation, le via 130 comporte en allant du haut vers le bas :
- quatre lignes de métal enfouies 132 à 135,
- des via métalliques 140 reliant électriquement entre eux les niveaux successifs de lignes de métal, et
- une ligne de métal 138 affleurant l'interface 40 de collage et située dans la sous-couche 120.

La ligne de métal 138 est directement en contact mécanique et électrique sur l'extrémité supérieure du via primaire 52. Ici, le réseau de métal d'interconnexion comporte cinq niveaux différents de lignes de métal. Par exemple, ces cinq niveaux de lignes de métal sont souvent désignés par les références, respectivement, M1 à M5. Le diamètre du via 130 est également inférieur à 3 µm ou 1 µm.

Des lignes 150 de redistribution, connues sous l'acronyme RDL (« ReDistribution Lines ») sont réalisées sur la face inférieure 34 pour raccorder électriquement les extrémités inférieures des via primaires à des microbilles de soudure correspondantes. A cet effet, les lignes de redistribution comportent des plots de raccordement sur lesquels sont directement fixées les microbilles de soudure. Sur la figure 1, seules trois microbilles de soudure 152 à 154 sont représentées. Ces microbilles 152 à 154 sont destinées à être soudées sur des plots correspondants de la face supérieure du support 14 et font donc partie du réseau 22 de microbilles de soudure. Ici, les lignes 150 sont enfouies à l'intérieur d'une couche 156 d'encapsulation réalisée dans un matériau électriquement non-conducteur tel qu'un polymère.

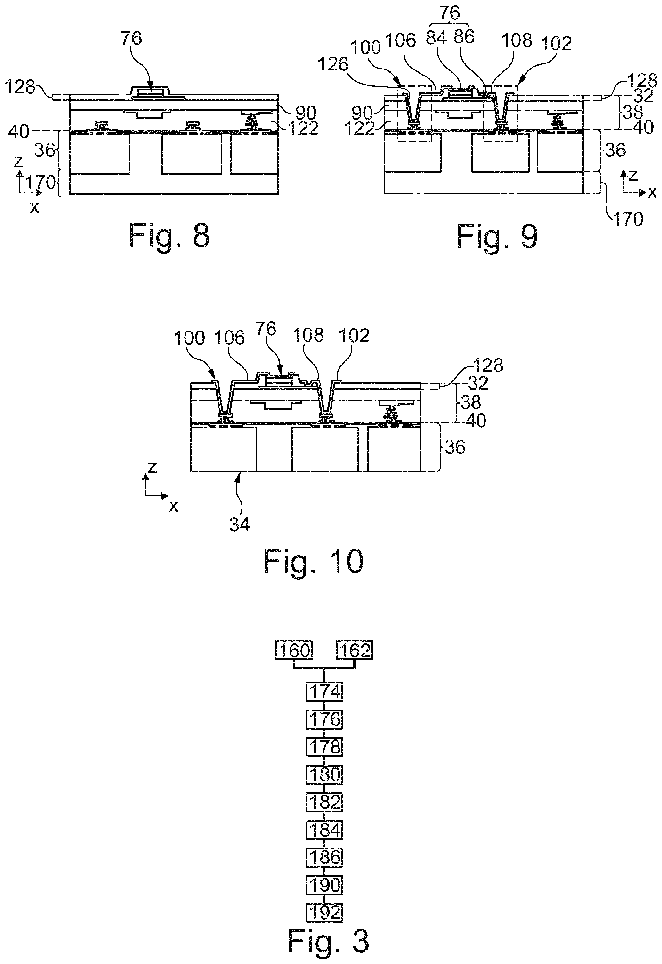

Un procédé de fabrication du système 2 va maintenant être décrit en référence à la figure 3 et aux différents états de fabrication représentés sur les figures 4 à 10.

Initialement, lors d'une étape 160, l'empilement des sous-couches 90, 122 et 120 est fabriquée sur une poignée 164 (figure 4) puis fournie. Ici, cet empilement constitue une partie seulement de la couche optique car il manque, à ce stade, notamment, la couche 128. A ce stade, la sous-couche 120 est située du côté opposé à la poignée 164 et présente une face 166 de collage. Cette face 166 est apte à être collée sur un autre substrat par collage direct, c'est-à-dire par un collage qui ne nécessite pas d'apport de matière.

L'étape 160 comporte également :
- la réalisation du guide d'onde 76 et du composant optique 72 à l'intérieur du niveau 92 de la sous-couche 122,
- la réalisation du via secondaire 130, et
- la réalisation des parties inférieures 110 des via secondaires 100 et 102.

La sous-couche 90 est directement fixée sur la poignée 164. La poignée 164 est un support qui permet de manipuler aisément l'empilement des sous-couche 120, 122 et 90. A cet effet, l'épaisseur de la poignée 164 est typiquement supérieure à 250 µm ou 500 µm. Par exemple, ici, la poignée 164 est un substrat en silicium d'épaisseur 750 µm ou 775 µm.

De préférence, la sous-couche 90 est la couche d'oxyde enfouie d'un substrat connu sous l'acronyme SOI (« Silicon On Insulator »). Dans ce cas, le guide d'onde 76 et le composant 72 sont réalisés, typiquement par gravure, dans la couche de silicium monocristallin de ce substrat SOI. Une fois que le guide d'onde 76 et le composant optique 72 ont été réalisés sur la sous-couche 90, ceux-ci sont enterrés dans le matériau diélectrique de la sous-couche 122 en déposant successivement plusieurs couches d'oxyde les unes après les autres. Lors des dépôts de ces couches d'oxyde successives, les réseaux de métal d'interconnexion formant le via secondaire 130 et les parties inférieures 110 des via secondaires 100 et 102 sont réalisés. Ainsi, ces réseaux de métal d'interconnexion sont réalisés à partir du côté opposé à la poignée 164. Les méthodes de réalisation des composants optiques sur la sous-couche 90, les méthodes d'enfouissement de composants à l'intérieur de la sous-couche 122 et les méthodes de réalisation de réseaux de métal d'interconnexion sont bien connues et ne sont donc pas décrites ici plus en détail. On notera qu'à ce stade du procédé de fabrication, la réalisation des parties supérieures 112 des via secondaires 100 et 102 est impossible. La sous-couche 122 ne comporte donc pas, à ce stade, les parties supérieures 112 des via 100 et 102.

En parallèle, lors d'une étape 162, la couche 36 d'interconnexion est fabriquée sur une poignée 170 (figure 5) puis fournie. Dans cet état, la couche 36 présente une face extérieure 172 située du côté opposé à la poignée 170. Cette face 172 est une face de collage, c'est-à-dire apte à être collée, par collage direct, sur la face 166. L'épaisseur de la poignée 170 est supérieure à 250 µm ou 500 µm pour permettre une manipulation aisée de la couche 36. Ici, la poignée 170 est par exemple un substrat en silicium.

L'étape 162 comporte également la réalisation des via primaires 50 à 52 dans la couche 36. Ainsi, à l'issue de l'étape 162, la couche 36 comporte ces via primaires 50 à 52. La réalisation d'une telle couche 36 sur la poignée 170 et la réalisation des via 50 à 52 dans cette couche 36 sont conventionnels. Par exemple, les parties 54 des vias 50 à 52 sont constitués d'un revêtement en matériau diélectrique, recouvert d'une couche barrière de Titane ou de Tantale, et rempli de cuivre. Un procédé de fabrication de ces parties 54 est par exemple décrit dans l'article de Ken Miyairi précédemment cité. Ensuite, les via métalliques 60 sont réalisés, en contact électrique avec les parties 54 des via primaires. Enfin, les lignes de métal telles que la ligne de métal 58, sont réalisées puis encapsulées dans la sous-couche 44 d'oxyde. La face extérieure de la sous-couche 44 est alors préparée pour son collage direct sur la face 166.

Lors d'une étape 174, les faces 166 et 172 sont collées, par collage direct, l'une sur l'autre. Ceci est représenté sur la figure 6. L'interface de collage 40 est alors obtenue. Par exemple, il s'agit d'un collage direct hybride cuivre-oxyde tel que décrit dans l'article suivant : Yan Beillard et Al : « Chip to wafer copper direct bonding electrical characterization and thermal cycling », 3D Systems Integration Conférence (3DIC), 2013 IEEE International.

Ensuite, lors d'une étape 176, la poignée 164 est retirée pour mettre à nu la sous-couche 90 (figure 7). Par exemple, la poignée 164 est retirée par polissage mécanique et chimique connu sous l'acronyme CMP (« Chemical Mechanical Polishing »), puis par gravure chimique sélective.

Lors d'une étape 178, la partie amplificatrice de lumière du composant 70 est réalisée sur la sous-couche 90, du côté opposé au niveau 92 de guidage optique (figure 8) et encapsulée dans le matériau diélectrique de la couche 128 d'encapsulation.

Lors d'une étape 180, les prises 84, 86, les pistes électriques 106 et 108 et les parties supérieures 112 des via secondaires 100 et 102 sont réalisées (figure 9). Par exemple, des trous tels que le trou 126 sont d'abord creusés à travers les sous-couches 128, 90 et du niveau 92 de la sous-couche 122. Ensuite, un revêtement en matériau conducteur est déposé sur toute la face extérieure. Enfin, ce revêtement conducteur est gravé pour ne laisser subsister le revêtement conducteur qu'aux emplacements des prises 84, 86, des pistes 106 et 108 et des parties supérieures 112 des via secondaires 100 et 102. La réalisation de la couche 38 est alors terminée.

Lors d'une étape 182, la poignée 170 est alors retirée à son tour pour mettre à nu la face inférieure 34 (figure 10).

Lors d'une étape 184, les lignes de redistribution 150, les microbilles de soudure 152 à 154 et la couche 156 d'encapsulation sont réalisées sur la face inférieure 34 mise à nu. La fabrication de la puce photonique 18 est alors terminée.

Lors d'une étape 186, la puce électronique 16 et la puce photonique 18 sont soudées sur des plots de la face supérieure du support 14. Les puces 16 et 18 sont alors connectées électriquement l'une à l'autre par l'intermédiaire des connexions horizontales du support 14.

Lors d'une étape 190, le support 14 et les puces 16 et 18 sont encapsulés dans un matériau électriquement non-conducteur et bon conducteur thermique tel qu'une résine epoxy. De plus, de préférence, un capot sur lequel est disposé un dissipateur thermique, tel qu'un radiateur, est fixés sur les faces supérieures des puces 16 et 18. Ce capot est par exemple collé, à l'aide d'une colle thermiquement conductrice, directement sur la face supérieure 32 de la puce photonique 18 et la face supérieure de la puce 16. Ainsi, ces faces supérieures peuvent être directement en contact avec la colle thermique qui est en contact avec le capot. Ceci est rendu possible par le fait que tous les signaux électriques et les alimentations électriques sont amenés par les faces inférieures des puces 16 et 18.

Ensuite, lors d'une étape 192, le système 2 est par exemple soudé sur le circuit imprimé 4.

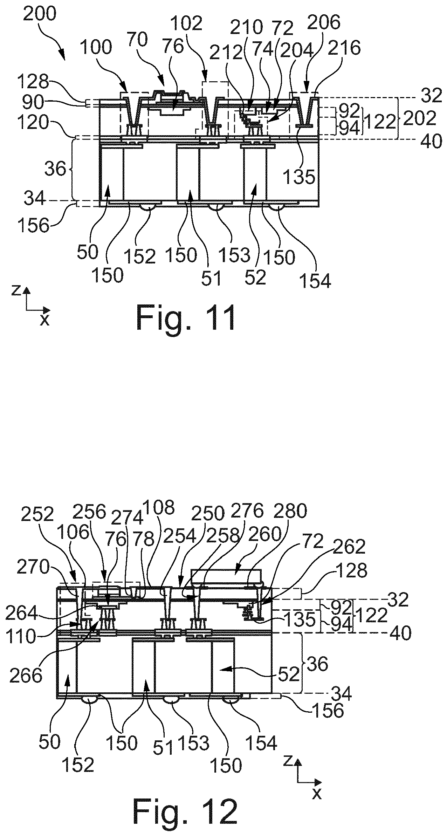

La figure 11 représente une puce photonique 200 qui peut être utilisée à la place de la puce photonique 18 dans le système 2. La puce 200 est identique à la puce 18 sauf que :
- la couche optique 38 est remplacée par une couche optique 202,
- le via secondaire 130 est remplacé par un via secondaire non-traversant 204, et
- la puce photonique 200 comporte un via tertiaire 206.

La couche optique 202 est identique à la couche optique 38 sauf qu'elle comporte en plus un composant électronique actif 210 enterré à l'intérieur du niveau 92 de la sous-couche 122. Ce composant électronique 210 est qualifié d'actif car, pour fonctionner, il a besoin d'être alimenté électriquement, et il émet et/ou reçoit un signal électrique. A cet effet, le composant 210 comporte un contact électrique 212 sur sa face inférieure. Ce contact électrique 212 est donc enfoui à l'intérieur de la sous-couche 122 et tourné vers l'interface 40 de collage.

Ici, le via secondaire 204 raccorde électriquement le contact électrique 212 du composant électronique 210 au via primaire 52 en traversant seulement le niveau inférieur 94 de la sous-couche 122 et la sous-couche 120. Le composant électronique 210 est, par exemple, destiné à fournir, à partir d'un signal électrique qu'il reçoit par le via primaire 52, un signal électrique de commande au composant optique 72. A cet effet, le composant 210 comporte sur sa face inférieure un autre contact électrique raccordé au contact 74 du composant 72. Pour cela, le réseau de métal d'interconnexion situé à l'intérieur du niveau 94 de la sous-couche 122 est modifié pour créé un chemin qui raccorde électriquement ensemble cet autre contact électrique et le contact 74. Pour simplifier la figure 11, cette modification du réseau de métal d'interconnexion n'a pas été représentée sur la figure 11. La structure et la fabrication du via 204 se déduisent des explications données pour le via 130.

Le via 206 est un via qui raccorde électriquement une ligne de métal 135, enfouie à l'intérieur du niveau 94 de la sous-couche 122, à une piste électrique 216 réalisée sur la face supérieure 32. Le via 206 s'étend verticalement depuis la face 32 jusqu'à la ligne 135 de métal enfouie en traversant notamment la sous-couche 90 et le niveau 92 de guidage optique.

La piste électrique 216 comporte un plot de test qui permet de tester le bon fonctionnement des composants 210 et/ou 72 au cours du procédé de fabrication de la puce photonique 200 et, en particulier, avant le retrait de la poignée 170. A cet effet, mais non représenté sur la figure 11, le réseau de métal d'interconnexion, situé à l'intérieur du niveau 94 de la sous-couche 122, est également modifié pour créer, à l'aide des lignes de métal et des via métalliques, un chemin électrique qui raccorde électriquement les contacts électriques 212 et/ou 74 à la ligne de métal 135.

La structure du via 206 est ici identique à celle du via 100 sauf qu'il est dépourvu de partie inférieure 110. Typiquement, le via 206 est fabriqué de la même manière que la partie supérieure 112 du via 100 et généralement en même temps que cette partie supérieure 112.

La figure 12 représente une puce photonique 250 susceptible d'être utilisée à la place de la puce photonique 18 dans le système 2. La puce photonique 250 est identique à la puce photonique 18 sauf que :
- les via secondaires traversants 100 et 102 sont remplacés par des via secondaires traversants, respectivement, 252 et 254,
- le composant 70 est remplacé par une source laser 256,
- le via secondaire 130 est remplacé par un via secondaire traversant 258, une puce électronique 260 et un via tertiaire 262.

Les via secondaires traversants 252 et 254 sont identiques, respectivement, aux via 100 et 102 sauf que leur partie supérieure 270 est réalisée différemment. Plus précisément, la partie supérieure 270 est ici un via plein. Autrement dit, la partie supérieure 270 est identique à la partie supérieure 112, sauf que l'évidement central du trou 126 est rempli d'un matériau conducteur. Généralement, dans ce cas, le diamètre maximal de la partie supérieure 270 des via 252 et 254 est inférieur à 1 µm.

La source laser 256 est identique au composant 70, sauf que la prise 86 est remplacée par une prise 274. La prise 274 est un via métallique qui raccorde électriquement la couche 78 à la piste électrique 108.

La face inférieure du guide d'onde 76 de la source laser 256 présente également un contact électrique 264. Ce contact électrique 264 est raccordé thermiquement à la couche 36 d'interconnexion par l'intermédiaire d'un via non traversant 266. Le via 266 est structurellement identique, par exemple, au via 130. Toutefois, contrairement au via 130, le via 266 n'a pas nécessairement pour fonction de raccorder électriquement le contact 264 à un via primaire de la couche 36. Ici, l'extrémité inférieure du via 264 est directement en contact mécanique et électrique avec une ligne de métal, située à l'intérieur de la sous-couche 44, qui affleure l'interface 40. Cette ligne de métal est ici électriquement isolée de tous les via primaires. Le via 266 est ici réalisé dans un matériau qui est un bon conducteur thermique. Un matériau « bon conducteur thermique » est typiquement un matériau dont la conductivité thermique est supérieure à 1,2C₁₂₂, et de préférence supérieure à 2C₁₂₂ ou 3C₁₂₂, où C₁₂₂ est la conductivité thermique du matériau diélectrique de la sous-couche 122. Ici, le matériau utilisé pour réaliser le via 266 est le même que celui utilisé pour réaliser le via 130. La présence du via 266 améliore la dissipation thermique de la chaleur produite par source laser 256. En effet , il est connu de l'homme de l'art que le guide d'onde 76 voit sa température augmenter lors du fonctionnement de la source laser 256. En absence du via 266, la présence du matériau diélectrique de la sous-couche 122 sous le guide d'onde 76 ne permet pas d'évacuer efficacement la chaleur produite. Le via 266 réalise un pont thermique, ici en métal, au travers de la sous-couche 122 qui raccorde thermiquement le guide d'onde 76 à la couche 36. Cela permet d'évacuer plus efficacement la chaleur produite par la source laser 256.

Le via secondaire traversant 258 raccorde électriquement et directement le via primaire 52 à une piste électrique 276 réalisée sur la face supérieure 32. La piste 276 comporte un plot sur lequel est soudé un premier contact électrique de la puce électronique 260. La structure du via 258 est ici identique à celle du via 252.

Le via 262 raccorde électriquement directement une piste électrique 280 réalisée sur la face supérieure 32 à la ligne de métal 135 enfouie à l'intérieur du niveau 94 de la sous-couche 122. A cet effet, par exemple, la structure du via 262 est identique à la structure du via 252 sauf que la partie inférieure 110 est omise. La piste électrique 280 comporte un plot sur lequel est soudé un second contact électrique de la puce électronique 260.

Ici, la ligne de métal 135 est électriquement raccordée au contact électrique 74 du composant optique 72 par l'intermédiaire d'un réseau de métal d'interconnexion similaire à celui décrit en référence à la figure 11. Typiquement, la puce électronique 260 est un transducteur, alimenté électriquement par des via primaires, qui commande le composant optique 72 en fonction de signaux électriques reçus par l'intermédiaire du via primaire, par exemple, 52.

### Chapitre II : Variantes :

### Chapitre II.1 : Variantes des via :

La section transversale horizontale d'un via n'est pas nécessairement circulaire. Par exemple, la section transversale d'un via peut être carrée ou rectangulaire. Dans ce cas, par « diamètre », on désigne le diamètre hydraulique de cette section transversale horizontale.

Comme illustré dans le cas du via secondaire dans les précédents modes de réalisation, le diamètre du via n'est pas nécessairement constant sur toute sa hauteur. Dans ce cas, par « diamètre » du via, on désigne le plus grand diamètre de ce via le long de sa hauteur.

En variante, la partie supérieure 56 du via primaire est omise. Dans ce cas, l'extrémité supérieure de la partie 54 du via primaire affleure directement l'interface 40 de collage.

Dans une autre variante, les via métalliques 60 sont omis. Dans ce cas, l'extrémité supérieure de la partie 54 est directement en contact mécanique et électrique avec la ligne de métal 58.

Dans un autre mode de réalisation, la partie supérieure 56 d'un via primaire peut comporter plusieurs lignes supplémentaires de métal réalisées à des profondeurs différentes à l'intérieur de la sous-couche 44. Les différents niveaux de lignes de métal de la partie 56 sont alors électriquement raccordés entre eux par des via métalliques. Ces lignes supplémentaires de métal forment alors une couche de redistribution ou RDL qui permet, par exemple, de raccorder électriquement entre elles plusieurs lignes de métal qui affleurent l'interface 40.

Le réseau de métal d'interconnexion utilisé pour former la partie inférieure d'un via secondaire traversant peut aussi, en variante, comporter plus de trois niveaux de lignes de métal.

En variante, la partie inférieure 110 d'un via secondaire traversant est omise. Dans ce cas, le fond du trou 126 débouche alors directement sur la ligne de métal 58 du via primaire. Un tel via secondaire traversant ne comporte alors qu'une seule partie, à savoir la partie 112.

Le centre du trou 126 peut aussi être rempli avec un matériau diélectrique différent du matériau diélectrique de la sous-couche 122. Par exemple, il est rempli d'un matériau organique.

### Chapitre II.2 : Autres variantes de la structure de la puce photonique :

En variante, la couche 36 d'interconnexion peut être réalisée dans d'autres matériaux que du silicium. Par exemple, elle est réalisée en verre.

Dans une autre variante, la couche 36 comporte un ou plusieurs composants électroniques.

Les sous-couches de la couche optique 38 peuvent aussi être réalisées dans d'autres matériaux. En particulier, la sous-couche 122 peut être réalisée à l'aide d'un autre matériau diélectrique comme par exemple du silicium amorphe, du nitrure de silicium SiN ou d'oxyde de nitrure de silicium SiON.

Les différentes sous-couches d'oxyde de la couche 38 ne sont pas nécessairement toutes réalisées dans le même oxyde. En variante, la sous-couche 120 est réalisée dans un oxyde différent de celui utilisé pour réaliser la sous-couche 90. Il est aussi possible d'utiliser un oxyde pour réaliser la sous-couche 122 qui est différent de celui de la sous-couche 90.

La couche optique peut en plus être traversée par des via supplémentaires dont le diamètre est supérieur à 3 µm et, par exemple, supérieur à 10 µm ou 20 µm. Dans ce cas, une zone d'exclusion de surface importante est prévue autour de chacun de ces via supplémentaires et aucun composant optique n'est réalisé à l'intérieur de cette zone d'exclusion. Cette zone d'exclusion est dimensionnée conformément à l'enseignement donné dans l'article Yang2013 précédemment cité. Toutefois, même si la puce photonique comporte quelques-uns de ces via supplémentaires, l'implantation des composants optiques dans la couche optique est quand même simplifiée à cause de la présence de via secondaires qui limite quand même les contraintes sur le placement des composants optiques.

Le nombre de composants optiques enterrés à l'intérieur du niveau 92 de la sous-couche 122 peut être quelconque. De plus, les différents composants optiques ne sont pas nécessairement enterrés à l'intérieur du niveau 92 à la même profondeur. C'est notamment le cas si les composants optiques ou parties de composants optiques sont fabriqués à partir de différentes sous-couches de matériau empilées les unes sur les autres. Ces sous-couches de matériau peuvent alors être choisies dans le groupe constitué d'une sous-couche de silicium cristallin, d'une sous-couche de silicium amorphe, d'une sous-couche de nitrure de silicium SiN et d'une sous-couche d'oxyde de nitrure de silicium SiON.

Dans un autre mode de réalisation, le composant 70 ou la source laser 256 est omise. Dans ce cas, la couche 128 d'encapsulation peut aussi être omise de sorte que la face supérieure 32 correspond alors à la face supérieure de la sous-couche 90.

En variante, l'extrémité inférieur du via secondaire 266 est électriquement et mécaniquement raccordée à au moins un via primaire. Ce via primaire n'est alors pas nécessairement utilisé pour établir une connexion électrique mais surtout pour améliorer la dissipation thermique de la chaleur produite par la source laser.

Le diamètre du via 266 n'est pas nécessairement inférieur à 3 µm ou 1 µm. Son diamètre peut aussi être supérieur à ces valeurs.

L'utilisation du via 266 pour améliorer la dissipation de la chaleur produite par une source laser s'applique de façon similaire à l'amélioration de la chaleur produite par tout type de composant optique ou électronique dont au moins une partie est enfouie à l'intérieur de la sous-couche 122. Par exemple, un via similaire au via 266 peut aussi être utilisé pour dissiper la chaleur produite par le composant optique 72 ou le composant électronique 210.

### Chapitre II.3 : Autres variantes :

La puce photonique peut comporter une piste électrique réalisée sur la face supérieure 32 qui n'est pas nécessairement utilisée pour raccorder électriquement un composant optique à l'un des via primaires. Par exemple, comme décrit dans le mode de réalisation de la figure 12, une telle piste électrique 276 peut être uniquement utilisée pour raccorder électriquement une puce électronique soudée sur la face supérieure 32 de la puce photonique à l'un des via primaires.

Dans un mode de réalisation, la puce photonique comporte seulement des via secondaires non-traversants. Dans ce cas, tous les via secondaires non-traversants sont fabriqués à partir du côté opposé à la poignée 164. L'ordre de retrait des poignées peut alors être inversé. Ainsi, la poignée 170 peut être retirée avant la poignée 164. En effet, il n'est pas nécessaire de fabriquer la partie supérieure 112 de via secondaires traversants. Dans ce cas également, le via secondaire non-traversant est entièrement fabriqué avant le collage de la couche 38 sur la couche 36.

Dans un autre mode de réalisation, la puce photonique comporte seulement des via secondaires traversants.

Alternativement la puce 260 peut correspondre à la puce 16 de la figure 1. Dans ce cas la puce électronique 260 est un ASIC alimenté électriquement par l'intermédiaire des via primaires, et qui commande le composant optique 72 avec des signaux électriques qu'il génère.

D'autres procédés de fabrication sont également possibles. Par exemple, dans le cas où aucune source laser n'est réalisée sur la sous-couche 90, après le retrait de la poignée 164 et après la réalisation de la partie supérieure 112 des via secondaires et avant le retrait de la poignée 170, la face extérieure située du côté opposé à cette poignée 170 est collée sur une nouvelle poignée, par exemple, réalisée en polymère. Ensuite, la poignée 170 est retirée, puis les lignes 150 de redistribution, les microbilles de soudure 152 à 154 et la couche 156 d'encapsulation sont réalisées. Enfin, la nouvelle poignée en polymère est retirée.

Le fait de connecter thermiquement une partie du composant 70 ou de la source laser 256 à la couche d'interconnexion par l'intermédiaire de via secondaires, typiquement non-traversant, comme le via 266, peut être mis en œuvre indépendamment des autres caractéristiques décrites ici de la puce photonique. En particulier, cela peut être mis en œuvre dans un contexte où les via primaires traversent la couche optique comme décrit dans l'article Yang2013 ou dans un contexte où tous les via primaires sont omis.

### Chapitre III : Avantages des modes de réalisation décrits :

Dans les modes de réalisation décrits, les via primaires ne génèrent pas de contrainte mécanique substantielle sur les composants optiques. En effet, la couche 36 d'interconnexion est totalement dépourvue de composant optique. Ceux-ci sont uniquement situés à l'intérieur de la couche. Par conséquent, les composants optiques peuvent être implantés les uns par rapport aux autres sans se soucier de la disposition des via primaires. En particulier, il n'est pas nécessaire de respecter une quelconque zone d'exclusion autour de chaque via primaire. Les via secondaires traversants le niveau 92 de guidage optique ont quant à eux un diamètre préférentiellement inférieur ou égal à 3 µm, voire à 1 µm. De tels via secondaires traversants peuvent ainsi être disposés à 4 µm voire à 2 µm des composants optiques sans générer de contraintes mécaniques sur ces derniers. Par comparaison les via traversants décrits dans Yang2013, de diamètre supérieur à 10 µm, doivent être disposés à 40 µm des composants optiques pour ne pas les contraindre mécaniquement. Il est donc possible de placer les composants optiques beaucoup plus près des via secondaires que ce qui aurait été possible si leur diamètre avait été égal au diamètre des via primaires. La combinaison dans une même puce photonique des via primaires et des via secondaires permet donc d'obtenir une puce photonique suffisamment épaisse pour avoir une flèche acceptable tout en limitant les contraintes à respecter pour placer les composants optiques par rapport aux via. On notera également que la couche d'interconnexion ne contient pas nécessairement de couche d'oxyde de silicium enterré. Son épaisseur minimale donnant lieu à une flèche acceptable est donc moindre que celle d'une couche qui contiendrait un oxyde de silicium enterré. Avoir une épaisseur moindre de la couche d'interconnexion permet notamment de diminuer les capacités parasites des via primaires. En effet, cette capacité parasite est proportionnelle à la hauteur des via primaires.

Pour la puce 18, le fait de placer la source laser sur la face supérieure de la couche d'oxyde 90 facilite son refroidissement à partir de l'extérieur, notamment grâce à la mise en boîtier du système.

Le fait que le centre du trou 126 soit rempli d'un matériau électriquement non-conducteur dont le coefficient de dilatation thermique est plus petit que celui du revêtement 124 permet de limiter encore plus les contraintes mécaniques exercées par le via secondaire sur les composants optiques situés à proximité.

Le fait de connecter thermiquement une partie du composant 70 ou de la source laser 256 à la couche d'interconnexion par l'intermédiaire de via secondaires, typiquement non-traversant, permet en plus d'améliorer la dissipation thermique de la chaleur produite par la source laser lors de son fonctionnement et cela tout en limitant les contraintes sur le positionnement des composants optiques par rapport aux via primaires.

## Revendications

1. Puce photonique s'étendant essentiellement dans un plan appelé « plan de la puce », cette puce photonique comportant :
- un substrat (30) présentant des faces supérieure (32) et inférieure (34) parallèles au plan de la puce, ce substrat comportant, entre les faces supérieure et inférieure :
• une couche (36) d'interconnexion d'épaisseur supérieure à 50 µm, cette couche d'interconnexion étant dépourvue de composant optique,
• une couche optique (38 ; 202) collée, au niveau d'une interface (40) de collage, sur la couche d'interconnexion,
• au moins un composant optique (70, 72 ; 256) enterré à l'intérieur de la couche optique (38 ; 202),
• une borne électrique choisie dans le groupe constitué d'un contact électrique (74 ; 212 ; 264) enfoui à l'intérieur de la couche optique (38 ; 202), ce contact électrique enfoui étant celui du composant optique (72) ou d'un composant électronique (210), et d'une piste électrique (106, 108 ; 276, 280) réalisée sur la face supérieure du substrat,
- des plots de raccordement électrique réalisés sur la face inférieure du substrat, chacun de ces plots étant apte à être connecté électriquement par l'intermédiaire d'une bille (152-154) de soudure à un autre support (14),
- un via primaire (50-52) s'étendant à travers la couche d'interconnexion depuis la face inférieure (34) pour raccorder électriquement l'un des plots de raccordement à la borne électrique, ce via primaire ayant un diamètre supérieur ou égal à 10 µm, **caractérisée en ce que** :
- l'épaisseur de la couche optique (38 ; 202) est inférieure à 15 µm,
- le via primaire (50-52) s'étend à travers la couche d'interconnexion uniquement entre la face inférieure (34) et l'interface (40) de collage de sorte que le via primaire ne se prolonge pas à l'intérieur de la couche optique (38 ; 202), et
- la puce photonique comporte un via secondaire (100, 102, 130 ; 204 ; 252, 254, 258) qui prolonge le via primaire à l'intérieur de la couche optique pour raccorder électriquement le via primaire à la borne électrique, ce via secondaire s'étendant à l'intérieur de la couche optique (38 ; 202) depuis l'interface (40) de collage jusqu'à la borne électrique, le diamètre maximal de ce via secondaire étant inférieur à 3 µm.

2. Puce photonique selon la revendication 1, dans laquelle
- la borne électrique est la piste électrique (106, 108 ; 276, 280) réalisée sur la face supérieure du substrat,
- la puce photonique comporte une ligne de métal (114) enfouie à l'intérieur de la couche optique (38 ; 202), cette ligne de métal enfouie s'étendant principalement dans un plan parallèle au plan de la puce,
- le via secondaire comporte :
• une première partie (110) du via secondaire qui s'étend, à travers la couche optique depuis l'interface de collage jusqu'à la ligne de métal enfouie, et
• une seconde partie (112) du via secondaire qui s'étend, à travers la couche optique, depuis la ligne de métal enfouie jusqu'à la borne électrique, cette seconde partie de via secondaire raccordant électriquement la ligne de métal (114) enfouie à la borne électrique.

3. Puce photonique selon la revendication 2, dans laquelle :
- la première partie (110) du via secondaire comporte des via métalliques (118) qui raccordent électriquement entre-elles des lignes de métal (114, 116) qui s'étendent principalement parallèlement au plan de la puce, ces lignes de métal étant disposées les une au-dessus des autres à l'intérieur de la couche optique (38 ; 202), le plus grand diamètre des ces via métalliques étant inférieur à 3 µm, et
- la seconde partie (112) du via secondaire comporte un revêtement (124) en matériau conducteur déposé sur une paroi d'un trou (126), ce trou étant creusé à partir de la face supérieure jusqu'à la ligne de métal (114) et étant rempli en son centre d'un matériau électriquement non-conducteur, le coefficient de dilatation thermique de ce matériau électriquement non-conducteur étant inférieur à 0,8C₁₂₄, où C₁₂₄ est le coefficient de dilatation thermique du revêtement.

4. Puce photonique conforme à la revendication 1, dans laquelle la borne électrique est le contact électrique enfoui (74 ; 212) du composant optique (72) ou électronique (210).

5. Puce photonique conforme à la revendication 4, dans laquelle le via secondaire (130) s'étend, à travers la couche optique, de l'interface de collage directement jusqu'à la borne électrique (74 ; 212), pour raccorder électriquement cette borne électrique au via primaire.

6. Puce photonique conforme à la revendication 1, dans laquelle :
- la borne électrique est le contact électrique enfoui (74 ; 212) du composant optique (72) ou électronique (210),
- la puce photonique comporte :
• une piste électrique (216) réalisée sur la face supérieure du substrat,
• une ligne (135) de métal enfouie à l'intérieur de la couche optique, cette ligne de métal étant électriquement raccordée à la borne électrique et s'étendant principalement parallèlement au plan de la puce,
• un via tertiaire (206) qui s'étend depuis la ligne de métal enfouie jusqu'à la piste électrique réalisée sur la face supérieure du substrat, le diamètre de ce via tertiaire étant inférieur à 3 µm.

7. Puce photonique conforme à l'une quelconque des revendications précédentes, dans laquelle :
- le couche optique comporte successivement, en allant de la face supérieure vers l'interface de collage (40) :
• une sous-couche (90) d'oxyde, au moins une partie (76) du composant optique (70, 72 ; 256) ou électronique (210) étant réalisée sur le coté de cette sous-couche (90) d'oxyde tourné vers l'interface (40) de collage, et
• une sous-couche (122) d'encapsulation dans laquelle ladite au moins une partie (76) du composant optique ou électronique est encapsulée dans un matériau diélectrique,
- ladite au moins une partie (76) du composant optique (70, 72 ; 256) ou électronique (210) comporte un contact électrique (264) enfoui à l'intérieur de la sous-couche (122) d'encapsulation,
- la puce optique comporte un via supplémentaire (266) qui s'étend à l'intérieur de la couche optique depuis l'interface (40) de collage jusqu'au contact électrique enfoui (264) de ladite au moins une partie (76) du composant optique (256) ou électronique, ce via supplémentaire étant réalisé dans un matériau dont la conductivité thermique est supérieure à 1,2C₁₂₂, où C₁₂₂ est la conductivité thermique du matériau diélectrique de la sous-couche (122) d'encapsulation.

8. Puce photonique conforme à la revendication 7, dans laquelle le via supplémentaire (266) est électriquement isolé de tout via primaire.

9. Puce photonique conforme à la revendication 7 ou 8, dans laquelle le composant optique dont au moins une partie est encapsulée dans la sous-couche (122) d'encapsulation est une source laser (256).

10. Puce photonique conforme à l'une quelconque des revendications précédentes, dans laquelle le diamètre maximal du via secondaire est inférieur à 1 µm.

11. Procédé de fabrication d'une puce photonique conforme à l'une quelconque des revendications précédentes, **caractérisé en ce que** le procédé comporte les étapes suivantes:
- la fourniture (160) d'au moins une partie de la couche optique (38 ; 202) fixée sur une première poignée (164) d'épaisseur supérieure à 250 µm, ladite au moins une partie de la couche optique (38 ; 202) comportant au moins un composant optique (70, 72 ; 256) enterré à l'intérieur de cette partie de la couche optique (38 ; 202),
- la fourniture (162) de la couche d'interconnexion d'épaisseur supérieure à 50 µm fixée sur une deuxième poignée (170) d'épaisseur supérieure à 250 µm, la couche d'interconnexion comportant :
• le via primaire (50-52) qui traverse la couche d'interconnexion, ce via primaire étant destiné à raccorder électriquement un plot de raccordement à une borne électrique choisie dans le groupe constitué d'un contact électrique (74 ; 212 ; 264) enfoui à l'intérieur de la couche optique (38 ; 202), ce contact électrique enfoui étant celui du composant optique (72) ou d'un composant électronique (210), et d'une piste électrique (106, 108 ; 276, 280) réalisée sur la face supérieure du substrat, ce via primaire ayant un diamètre supérieur ou égal à 10 µm,
• une deuxième face (172) de collage du côté opposé à la deuxième poignée, et
• la couche d'interconnexion étant dépourvue de composant optique, puis
- le collage (174) de la première face de collage sur la deuxième face de collage pour obtenir l'interface (40) de collage, puis
- le retrait (176) de la première poignée pour mettre à nu une sous-couche (90) d'oxyde de ladite au moins une partie de la couche optique,
- le retrait (182) de la deuxième poignée pour mettre à nu la face inférieure (34) du substrat de la puce photonique puis la réalisation sur cette face inférieure des plots de raccordement électrique, chacun de ces plots étant apte à être connecté à un autre support (14) par l'intermédiaire d'une bille de soudure,
- avant ou après le collage, la fabrication (160, 180) d'un via secondaire apte à prolonger le via primaire à l'intérieur de la couche optique pour raccorder électriquement le via primaire à la borne électrique, ce via secondaire s'étendant à l'intérieur de la couche optique depuis l'interface de collage jusqu'à la borne électrique, le diamètre maximal de ce via secondaire étant inférieur à 3 µm.

12. Procédé selon la revendication 11, dans lequel la fabrication du via secondaire comporte :
- avant le collage et avant le retrait de la première poignée, la réalisation (160) d'une première partie du via secondaire, cette réalisation d'une première partie du via secondaire comportant la réalisation :
• d'au moins une ligne (114) de métal enfouie à l'intérieur de ladite au moins une partie de la couche optique et d'une ligne (116) de métal affleurant la première face de collage, chacune de ces lignes de métal s'étendant principalement dans un plan parallèle au plan de la puce, et
• de via métalliques (118) qui raccordent électriquement entre elles les lignes de métal, et
- après le collage et après le retrait de la première poignée, la réalisation (180), depuis la face supérieure du substrat :
• d'une piste électrique sur cette face supérieure, cette piste électrique formant ladite borne électrique, et
• d'une seconde partie du via secondaire qui s'étend, à travers la couche optique, depuis la ligne de métal enfouie jusqu'à la face supérieure, cette seconde partie du via secondaire raccordant électriquement la ligne de métal à la borne électrique.

13. Procédé selon la revendication 12, dans lequel la réalisation (180) de la seconde partie du via secondaire comporte :
- la réalisation depuis la face supérieure, d'un trou (126) débouchant sur la ligne de métal enfouie, puis
- le dépôt sur les parois de ce trou d'un revêtement (124) en matériau électriquement conducteur pour raccorder électriquement la ligne de métal à la borne électrique, puis
- le dépôt d'un matériau électriquement non-conducteur au centre de ce trou pour le reboucher, le coefficient de dilatation thermique de ce matériau électriquement non-conducteur étant inférieur à 0,8C₁₂₄, où C₁₂₄ est le coefficient de dilatation thermique du revêtement.

## Patentansprüche

1. Photonischer Chip, der sich im Wesentlichen in einer "Ebene des Chips" genannten Ebene erstreckt, wobei dieser photonische Chip aufweist:
- ein Substrat (30), das eine Oberseite (32) und eine Unterseite (34) parallel zur Ebene des Chips aufweist, wobei dieses Substrat zwischen der Ober- und Unterseite aufweist:
• eine Verbindungsschicht (36) einer Dicke von mehr als 50 µm, wobei diese Verbindungsschicht kein optisches Bauteil aufweist,
• eine optische Schicht (38; 202), die im Bereich einer Klebeverbindungsfläche (40) auf die Verbindungsschicht geklebt ist,
• mindestens ein optisches Bauteil (70, 72; 256), das innerhalb der optischen Schicht (38; 202) eingegraben ist,
• einen elektrischen Anschluss ausgewählt aus der Gruppe, die aus einem im Inneren der optischen Schicht (38; 202) vergrabenen elektrischen Kontakt (74; 212; 264), wobei dieser vergrabene elektrische Kontakt derjenige des optischen Bauteils (72) oder eines elektronischen Bauteils (210) ist, und aus einem Strompfad (106, 108; 276, 280) besteht, der an der Oberseite des Substrats hergestellt ist,
- elektrische Anschlusskontaktstellen, die an der Unterseite des Substrats hergestellt sind, wobei jede dieser Kontaktstellen mittels einer Lötperle (152-154) elektrisch mit einem anderen Träger (14) verbunden werden kann,
- eine Primärdurchkontaktierung (50-52), die sich von der Unterseite (34) durch die Verbindungsschicht hindurch erstreckt, um eine der Anschlusskontaktstellen elektrisch an den elektrischen Anschluss anzuschließen, wobei diese Primärdurchkontaktierung einen Durchmesser größer als oder gleich 10 µm hat,
**dadurch gekennzeichnet, dass**:
- die Dicke der optischen Schicht (38; 202) geringer als 15 µm ist,
- die Primärdurchkontaktierung (50-52) sich durch die Verbindungsschicht hindurch nur zwischen der Unterseite (34) und der Klebeverbindungsfläche (40) erstreckt, so dass die Primärdurchkontaktierung sich nicht ins Innere der optischen Schicht (38; 202) verlängert, und
- der photonische Chip eine Sekundärdurchkontaktierung (100, 102, 130; 204; 252, 254, 258) aufweist, die die Primärdurchkontaktierung im Inneren der optischen Schicht verlängert, um die Primärdurchkontaktierung elektrisch an den elektrischen Anschluss anzuschließen, wobei diese Sekundärdurchkontaktierung sich im Inneren der optischen Schicht (38; 202) von der Klebeverbindungsfläche (40) bis zum elektrischen Anschluss erstreckt, wobei der maximale Durchmesser dieser Sekundärdurchkontaktierung geringer als 3 µm ist.

2. Photonischer Chip nach Anspruch 1, wobei
- der elektrischer Anschluss der an der Oberseite des Substrats hergestellte Strompfad (106, 108; 276, 280) ist,
- der photonische Chip eine im Inneren der optischen Schicht (38; 202) vergrabene Metallleitung (114) aufweist, wobei diese vergrabene Metallleitung sich hauptsächlich in einer Ebene parallel zur Ebene des Chips erstreckt,
- die Sekundärdurchkontaktierung aufweist:
• einen ersten Teil (110) der Sekundärdurchkontaktierung, der sich durch die optische Schicht hindurch von der Klebeverbindungsfläche bis zur vergrabenen Metallleitung erstreckt, und
• einen zweiten Teil (112) der Sekundärdurchkontaktierung, der sich durch die optische Schicht hindurch von der vergrabenen Metallleitung bis zum elektrischen Anschluss erstreckt, wobei dieser zweite Teil der Sekundärdurchkontaktierung die vergrabene Metallleitung (114) elektrisch an den elektrischen Anschluss anschließt.

3. Photonischer Chip nach Anspruch 2, wobei
- der erste Teil (110) der Sekundärdurchkontaktierung metallische Durchkontaktierungen (118) aufweist, die Metallleitungen (114, 116) elektrisch aneinander anschließen, die sich hauptsächlich parallel zur Ebene des Chips erstrecken, wobei diese Metallleitungen im Inneren der optischen Schicht (38; 202) übereinander angeordnet sind, wobei der größte Durchmesser dieser metallischen Durchkontaktierungen kleiner als 3 µm ist, und
- der zweite Teil (112) der Sekundärdurchkontaktierung eine Beschichtung (124) aus leitendem Material aufweist, die auf eine Wand eines Lochs (126) aufgebracht ist, wobei dieses Loch ausgehend von der Oberseite bis zur Metallleitung (114) ausgehöhlt ist und in seiner Mitte mit einem elektrisch nicht leitenden Material gefüllt ist, wobei der Wärmedehnungskoeffizient dieses elektrisch nicht leitenden Materials niedriger als 0,8C₁₂₄ ist, wobei C₁₂₄ der Wärmedehnungskoeffizient der Beschichtung ist.

4. Photonischer Chip nach Anspruch 1, wobei der elektrische Anschluss der vergrabene elektrische Kontakt (74; 212) des optischen (72) oder elektronischen (210) Bauteils ist.

5. Photonischer Chip nach Anspruch 4, wobei die Sekundärdurchkontaktierung (130) sich durch die optische Schicht hindurch von der Klebeverbindungsfläche direkt bis zum elektrischen Anschluss (74; 212) erstreckt, um diesen elektrischen Anschluss elektrisch an die Primärdurchkontaktierung anzuschließen.

6. Photonischer Chip nach Anspruch 1, wobei:
- der elektrische Anschluss der vergrabene elektrische Kontakt (74; 212) des optischen (72) oder elektronischen (210) Bauteils ist,
- der photonische Chip aufweist:
• einen an der Oberseite des Substrats hergestellten Strompfad (216),
• eine im Inneren der optischen Schicht vergrabene Metallleitung (135), wobei diese Metallleitung elektrisch an den elektrischen Anschluss angeschlossen ist und sich hauptsächlich parallel zur Ebene des Chips erstreckt,
• eine Tertiärdurchkontaktierung (206), die sich von der vergrabenen Metallleitung bis zu dem an der Oberseite des Substrats hergestellten Strompfad erstreckt, wobei der Durchmesser dieser Tertiärdurchkontaktierung kleiner als 3 µm ist.

7. Photonischer Chip nach einem der vorhergehenden Ansprüche, wobei:
- die optische Schicht von der Oberseite zur Klebeverbindungsfläche (40) nacheinander aufweist:
• eine Oxid-Teilschicht (90), wobei mindestens ein Teil (76) des optischen (70, 72; 256) oder elektronischen (210) Bauteils auf der Seite dieser Oxid-Teilschicht (90) hergestellt ist, die zur Klebeverbindungsfläche (40) weist, und
• eine Verkapselungs-Teilschicht (122), in der der mindestens eine Teil (76) des optischen oder elektronischen Bauteils in einem dielektrischen Material verkapselt ist,
- der mindestens eine Teil (76) des optischen (70, 72; 256) oder elektronischen (210) Bauteils einen elektrischen Kontakt (264) aufweist, der innerhalb der Verkapselungs-Teilschicht (122) vergraben ist,
- der optische Chip eine zusätzliche Durchkontaktierung (266) aufweist, die sich im Inneren der optischen Schicht von der Klebeverbindungsfläche (40) bis zum vergrabenen elektrischen Kontakt (264) des mindestens einen Teils (76) des optischen (256) oder elektronischen Bauteils erstreckt, wobei diese zusätzliche Durchkontaktierung aus einem Material hergestellt ist, dessen Wärmeleitfähigkeit höher als 1,2C₁₂₂ ist, wobei C₁₂₂ die Wärmeleitfähigkeit des dielektrischen Materials der Verkapselungs-Teilschicht (122) ist.

8. Photonischer Chip nach Anspruch 7, wobei die zusätzliche Durchkontaktierung (266) von jeder Primärdurchkontaktierung elektrisch isoliert ist.

9. Photonischer Chip nach Anspruch 7 oder 8, wobei das optische Bauteil, von dem mindestens ein Teil in der Verkapselungs-Teilschicht (122) verkapselt ist, eine Laserquelle (256) ist.

10. Photonischer Chip nach einem der vorhergehenden Ansprüche, wobei der maximale Durchmesser der Sekundärdurchkontaktierung kleiner als 1 µm ist.

11. Verfahren zur Herstellung eines photonischen Chips nach einem der vorhergehenden Ansprüche, **dadurch gekennzeichnet, dass** das Verfahren die folgenden Schritte aufweist:
- die Bereitstellung (160) mindestens eines Teils der optischen Schicht (38; 202) befestigt an einem ersten Griff (164) einer Dicke von mehr als 250 µm, wobei der mindestens eine Teil der optischen Schicht (38; 202) mindestens ein optisches Bauteil (70, 72; 256) aufweist, das innerhalb dieses Teils der optischen Schicht (38; 202) eingegraben ist,
- die Bereitstellung (162) der Verbindungsschicht einer Dicke von mehr als 50 µm befestigt an einem zweiten Griff (170) einer Dicke von mehr als 250 µm, wobei die Verbindungsschicht aufweist:
• die Primärdurchkontaktierung (50-52), die die Verbindungsschicht durchquert, wobei diese Primärdurchkontaktierung dazu bestimmt ist, eine Anschlusskontaktstelle elektrisch an einen elektrischen Anschluss anzuschließen, der aus der Gruppe bestehend aus einem innerhalb der optischen Schicht (38; 202) vergrabenen elektrischen Kontakt (74; 212; 264), wobei dieser vergrabene elektrische Kontakt derjenige des optischen Bauteils (72) oder eines elektronischen Bauteils (210) ist, und einem an der Oberseite des Substrats hergestellten Strompfad (106, 108; 276, 280) ausgewählt wird, wobei diese Primärdurchkontaktierung einen Durchmesser von mehr als oder gleich 10 µm hat,
• eine zweite Klebeseite (172) auf der dem zweiten Griff entgegengesetzten Seite, und
• die kein optisches Bauteil aufweisende Verbindungsschicht, dann
- das Kleben (174) der ersten Klebeseite auf die zweite Klebeseite, um die Klebeverbindungsfläche (40) zu erhalten, dann
- das Entfernen (176) des ersten Griffs, um eine Oxid-Teilschicht (90) des mindestens einen Teils der optischen Schicht zu entblößen,
- das Entfernen (182) des zweiten Griffs, um die Unterseite (34) des Substrats des photonischen Chips zu entblößen, dann die Herstellung der elektrischen Anschlusskontaktstellen auf dieser Unterseite, wobei jede dieser Kontaktstellen mittels einer Lötperle mit einem anderen Träger (14) verbunden werden kann,
- vor oder nach dem Kleben die Herstellung (160, 180) einer Sekundärdurchkontaktierung, die die Primärdurchkontaktierung im Inneren der optischen Schicht verlängern kann, um die Primärdurchkontaktierung elektrisch an den elektrischen Anschluss anzuschließen, wobei diese Sekundärdurchkontaktierung sich im Inneren der optischen Schicht von der Klebeverbindungsfläche bis zum elektrischen Anschluss erstreckt, wobei der maximale Durchmesser dieser Sekundärdurchkontaktierung kleiner als 3 µm ist.

12. Verfahren nach Anspruch 11, wobei die Herstellung der Sekundärdurchkontaktierung aufweist:
- vor dem Kleben und vor dem Entfernen des ersten Griffs die Herstellung (160) eines ersten Teils der Sekundärdurchkontaktierung, wobei diese Herstellung eines ersten Teils der Sekundärdurchkontaktierung die Herstellung aufweist:
• mindestens einer innerhalb des mindestens einen Teils der optischen Schicht vergrabenen Metallleitung (114) und einer Metallleitung (116), die die erste Klebefläche berührt, wobei jede dieser Metallleitungen sich hauptsächlich in einer Ebene parallel zur Ebene des Chips erstreckt, und
• metallische Durchkontaktierungen (118), die die Metallleitungen elektrisch aneinander anschließen, und
- nach dem Kleben und nach dem Entfernen des ersten Griffs, die Herstellung (180) ausgehend von der Oberseite des Substrats:
• eines Strompfads auf dieser Oberseite, wobei dieser Strompfad den elektrischen Anschluss bildet, und
• eines zweiten Teils der Sekundärdurchkontaktierung, der sich durch die optische Schicht hindurch von der vergrabenen Metallleitung bis zur Oberseite erstreckt, wobei dieser zweite Teil der Sekundärdurchkontaktierung die Metallleitung elektrisch an den elektrischen Anschluss anschließt.

13. Verfahren nach Anspruch 12, wobei die Herstellung (180) des zweiten Teils der Sekundärdurchkontaktierung aufweist:
- die Herstellung eines auf die vergrabene Metallleitung mündenden Lochs (126) ausgehend von der Oberseite, dann
- das Abscheiden einer Beschichtung (124) aus elektrisch leitendem Material auf die Wände dieses Lochs, um die Metallleitung elektrisch an den elektrischen Anschluss anzuschließen, dann
- das Abscheiden eines elektrisch nicht leitenden Materials in der Mitte dieses Lochs, um es wieder zu verschließen, wobei der Wärmedehnungskoeffizient dieses elektrisch nicht leitenden Materials niedriger als 0,8C₁₂₄ ist, wobei C₁₂₄ der Wärmedehnungskoeffizient der Beschichtung ist.

## Claims

1. Photonic chip lying essentially in a plane called the "plane of the chip", this photonic chip comprising:
- a substrate (30) having an upper face (32) and a lower face (34) that are parallel to the plane of the chip, this substrate comprising, between the upper and lower faces:
• an interconnection layer (36) of thickness larger than 50 µm, this interconnection layer being devoid of optical components,
• an optical layer (38; 202) bonded, at a bonding interface (40), to the interconnection layer,
• at least one optical component (70, 72; 256) buried in the interior of the optical layer (38; 202),
• an electrical terminal chosen from the group consisting of an electrical contact (74; 212; 264) embedded in the interior of the optical layer (38; 202), this embedded electrical contact being that of the optical component (72) or of an electronic component (210), and of an electrical track (106, 108; 276, 280) produced on the upper face of the substrate,
- electrical connection pads produced on the lower face of the substrate, each of these pads being able to be electrically connected by way of a solder bump (152-154) to another carrier (14),
- a primary via (50-52) extending through the interconnection layer from the lower face (34) in order to electrically connect one of the connection pads to the electrical terminal, this primary via having a diameter larger than or equal to 10 µm,
**characterized in that**:
- the thickness of the optical layer (38; 202) is smaller than 15 µm,
- the primary via (50-52) extends through the interconnection layer solely between the lower face (34) and the bonding interface (40) so that the primary via does not extend into the interior of the optical layer (38; 202), and
- the photonic chip comprises a secondary via (100, 102, 130; 204; 252, 254, 258) that extends the primary via into the interior of the optical layer in order to electrically connect the primary via to the electrical terminal, this secondary via extending in the interior of the optical layer (38; 202) from the bonding interface (40) to the electrical terminal, the maximum diameter of this secondary via being smaller than 3 µm.

2. Photonic chip according to Claim 1, wherein
- the electrical terminal is the electrical track (106, 108; 276, 280) produced on the upper face of the substrate,
- the photonic chip comprises a metal line (114) embedded in the interior of the optical layer (38; 202), this embedded metal line lying mainly in a plane parallel to the plane of the chip,
- the secondary via comprises:
• a first portion (110) of the secondary via that extends, through the optical layer from the bonding interface to the embedded metal line, and
• a second portion (112) of the secondary via that extends, through the optical layer, from the embedded metal line to the electrical terminal, this second secondary-via portion electrically connecting the embedded metal line (114) to the electrical terminal.

3. Photonic chip according to Claim 2, wherein:
- the first portion (110) of the secondary via comprises metal vias (118) that electrically connect to each other metal lines (114, 116) that mainly extend parallel to the plane of the chip, these metal lines being placed one above the other in the interior of the optical layer (38; 202), the largest diameter of these metal vias being smaller than 3 µm, and
- the second portion (112) of the secondary via comprises a coating (124) made of conductive material deposited on a wall of a hole (126), this hole being dug from the upper face to the metal line (114) and being filled in its centre with an electrically non-conductive material, the coefficient of thermal expansion of this electrically non-conductive material being lower than 0.8C₁₂₄, where C₁₂₄ is the coefficient of thermal expansion of the coating.

4. Photonic chip according to Claim 1, wherein the electrical terminal is the embedded electrical contact (74; 212) of the optical component (72) or of the electronic component (210).

5. Photonic chip according to Claim 4, wherein the secondary via (130) extends, through the optical layer, from the bonding interface directly to the electrical terminal (74; 212), in order to electrically connect this electrical terminal to the primary via.

6. Photonic chip according to Claim 1, wherein:
- the electrical terminal is the embedded electrical contact (74; 212) of the optical component (72) or of the electronic component (210),
- the photonic chip comprises:
• an electrical track (216) produced on the upper face of the substrate,
• a metal line (135) embedded in the interior of the optical layer, this metal line being electrically connected to the electrical terminal and mainly extending parallel to the plane of the chip,
• a tertiary via (206) that extends from the embedded metal line to the electrical track produced on the upper face of the substrate, the diameter of this tertiary via being smaller than 3 µm.

7. Photonic chip according to any one of the preceding claims, wherein:
- the optical layer comprises successively, from the upper face to the bonding interface (40):
• an oxide sublayer (90), at least one portion (76) of the optical component (70, 72; 256) or of the electronic component (210) being produced on the side of this oxide sublayer (90) that is turned toward the bonding interface (40), and
• an encapsulation sublayer (122) in which said at least one portion (76) of the optical or electronic component is encapsulated in a dielectric material,
- said at least one portion (76) of the optical component (70, 72; 256) or of the electronic component (210) comprises an electrical contact (264) embedded in the interior of the encapsulation sublayer (122),
- the optical chip comprises an additional via (266) that extends in the interior of the optical layer from the bonding interface (40) to the embedded electrical contact (264) of said at least one portion (76) of the optical component (256) or of the electronic component, this additional via being made from a material the thermal conductivity of which is higher than 1.2C₁₂₂, where C₁₂₂ is the thermal conductivity of the dielectric material of the encapsulation sublayer (122).

8. Photonic chip according to Claim 7, wherein the additional via (266) is electrically insulated from any primary via.

9. Photonic chip according to Claim 7 or 8, wherein the optical component at least one portion of which is encapsulated in the encapsulation sublayer (122) is a laser source (256).

10. Photonic chip according to any one of the preceding claims, wherein the maximum diameter of the secondary via is smaller than 1 µm.

11. Process for fabricating a photonic chip according to any one of the preceding claims, **characterized in that** the process comprises the following steps:
- providing (160) at least one portion of the optical layer (38; 202) fastened to a first handle (164) of thickness larger than 250 µm, said at least one portion of the optical layer (38; 202) comprising at least one optical component (70, 72; 256) buried in the interior of this portion of the optical layer (38; 202),
- providing (162) the interconnection layer of thickness larger than 50 µm fastened to a second handle (170) of thickness larger than 250 µm, the interconnection layer comprising:
• the primary via (50-52) that passes through the interconnection layer, this primary via being intended to electrically connect a connection pad to an electrical terminal chosen from the group consisting of an electrical contact (74; 212; 264) embedded in the interior of the optical layer (38; 202), this embedded electrical contact being that of the optical component (72) or of an electronic component (210), and of an electrical track (106, 108; 276, 280) produced on the upper face of the substrate, this primary via having a diameter larger than or equal to 10 µm,
• a second bonding face (172) on the side opposite the second handle, and
• the interconnection layer being devoid of optical components, then
- bonding (174) the first bonding face to the second bonding face in order to obtain the bonding interface (40), then
- removing (176) the first handle in order to uncover an oxide sublayer (90) of said at least one portion of the optical layer,
- removing (182) the second handle in order to uncover the lower face (34) of the substrate of the photonic chip then producing on this lower face electrical connection pads, each of these pads being able to be connected to another carrier (14) by way of a solder bump,
- before or after the bonding, fabricating (160, 180) a secondary via able to extend the primary via into the interior of the optical layer in order to electrically connect the primary via to the electrical terminal, this secondary via extending in the interior of the optical layer from the bonding interface to the electrical terminal, the maximum diameter of this secondary via being smaller than 3 µm.

12. Process according to Claim 11, wherein the fabrication of the secondary via comprises:
- before the bonding and before the removal of the first handle, producing (160) a first portion of the secondary via, this production of a first portion of the secondary via comprising producing:
• at least one metal line (114) embedded in the interior of said at least one portion of the optical layer, and a metal line (116) flush with the first bonding face, each of these metal lines mainly lying in a plane parallel to the plane of the chip, and
• metal vias (118) that electrically connect the metal lines to each other, and
- after the bonding and after the removal of the first handle, producing (180), from the upper face of the substrate:
• an electrical track on this upper face, this electrical track forming said electrical terminal, and
• a second portion of the secondary via that extends, through the optical layer, from the embedded metal line to the upper face, this second portion of the secondary via electrically connecting the metal line to the electrical terminal.

13. Process according to Claim 12, wherein the production (180) of the second portion of the secondary via comprises:
- producing from the upper face, a hole (126) that emerges onto the embedded metal line, then
- depositing, on the walls of this hole, a coating (124) made of electrically conductive material in order to electrically connect the metal line to the electrical terminal, then
- depositing an electrically non-conductive material in the centre of this hole in order to plug it, the coefficient of thermal expansion of this electrically non-conductive material being lower than 0.8C₁₂₄, where C₁₂₄ is the coefficient of thermal expansion of the coating.
